Europäisches Patentamt

European Patent Office

Office européen des brevets

(19)

(11) Veröffentlichungsnummer: **0 109 576**
**A2**

(12) # EUROPÄISCHE PATENTANMELDUNG

(21) Anmeldenummer: **83110610.9**

(22) Anmeldetag: **24.10.83**

(51) Int. Cl.³: **H 01 L 27/06**

(30) Priorität: **22.11.82 JP 203564/82**

(43) Veröffentlichungstag der Anmeldung:
**30.05.84 Patentblatt 84/22**

(84) Benannte Vertragsstaaten:
**CH DE FR GB IT LI NL SE**

(71) Anmelder: **FUJI ELECTRIC CO. LTD.**
**1-1, Tanabeshinden, Kawasaki-ku**
**Kawasaki 210(JP)**

(72) Erfinder: **Hiroki, Fujiwara**
**2-16 Sakaecho 4-chome**
**Hino Tokyo(JP)**

(72) Erfinder: **Masami, Ichijo**
**33-3 Osakaue 1-chome**
**Hino Tokyo(JP)**

(74) Vertreter: **Mehl, Ernst, Dipl.-Ing. et al,**
**Postfach 22 01 76**
**D-8000 München 22(DE)**

(54) **Transistorelement.**

(57) Ein erster Feldeffekttransistor (4) ist mit Drain und Source zwischen Kollektor und Basis eines bipolaren Transistors (2) geschaltet. Durch eine entsprechende Steuerspannung auf dem Gate (G) kann dieser FET (4) den bipolaren Transistor nahezu verlustlos ein- und ausschalten. Ein zweiter Feldeffekttransistor (5) ist mit Drain und Source zwischen Basis und Emitter des bipolaren Transistors geschaltet und führt beim Sperren des bipolaren Transistors akkumulierte Ladungen rasch ab. Dadurch entsteht ein Schaltelement, das hohe Ströme bei niedrigen Steuerverlusten mit hoher Geschwindigkeit zu schalten ermöglicht.

FIG 2

EP 0 109 576 A2

FUJI ELECTRIC Co., Ltd.        Mein Zeichen:
Kawasaki / Japan               VPA 82 P 8 5 7 6  E

Transistorelement
(beansprucht wird die Priorität der japanischen Patentanmeldung T 57-20 35 64 vom 22.11.1982)

Die Erfindung betrifft ein aus mehreren Transistoren zusammengesetztes Transistorelement und die   Verwendung
des Elementes als Schaltelement bei Geräten der Leistungselektronik, insbesondere bei Stromrichtern.

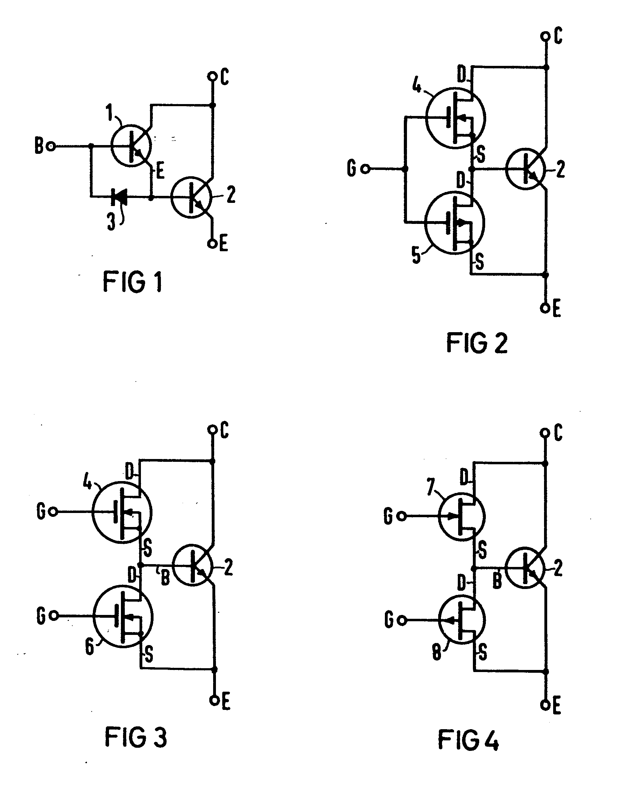

Als Beispiel eines üblichen Transistorschalters aus mehreren Transistoren ist in Fig. 1 eine Darlington-Schaltung dargestellt. Den Eingang dieser Transistorschaltung
bildet der Transistor 1 und den Ausgang der Transistor 2,
wobei die beiden Transistoren 1 und 2 miteinander in
Darlington-Verbindung geschaltet sind, um eine hohe Stromverstärkung zu erhalten. Beide Transistoren sind bipolare
npn-Transistoren und eine Beschleunigungsdiode 3 ist zwischen der Basis B und dem Emitter E des Transistors 1 geschaltet, um die akkumulierten Ladungsträger in einen
äußeren Schaltkreis abzuführen. Mit C ist der Kollektoranschluß und der mit E der Emitteranschluß dieser Transistorschaltung bezeichnet.

Derartige Darlington-Schaltungen von Transistoren besitzen
jedoch folgendes Verhalten:

Durch die Darlington-Schaltung der bipolaren Transistoren 1 und 2 wird die Emitter-Basis-Gleichstromverstärkung
üblicherweise auf etwa 50 bis 100 erhöht. Aber selbst
diese hohen Verstärkungsfaktoren verbrauchen hohe elektrische Leistungen, da z.B. ein Basisstrom von mehr als 1 A
erforderlich ist, um durch die Darlington-Transistoren
Ströme von 100 A zu leiten.

Kbl 2 Rch / 20.9.1983

Der Transistor 2 am Ausgang der Darlington-Schaltung arbeitet ferner bei Kollektor-Emitter-Spannungen, die über seiner spezifischen Sättigungsspannung liegen, d.h. im aktiven Bereich. Da daher die akkumulierten Ladungsträger im Ausgangstransistor 2 geringer sind als im Fall, daß dieser Transistor als Einzeltransistor verwendet würde, ist auch seine Abschaltzeit verringert. Die gesamte Abschaltzeit ist aber die Summe der Abschaltzeiten beider Transistoren und die Abschaltzeit des Eingangstransistors 1 ist üblicherweise sehr viel länger als die des Ausgangstransistors 2. Diese wird zwar durch einen entgegengesetzt gerichteten Strom über die Diode 3 verkürzt, der in der Basiszone während der Leitfähigkeitsphase die akkumulierte Ladungswolke nach außen abführt, aber die gesamte Abschaltzeit ist immer noch länger als im Fall, daß nur ein einziger Transistor verwendet würde. Dadurch kann also die Schaltgeschwindigkeit nicht beschleunigt werden. Dies ist eine Folge davon, daß die Wirkung der Ladungsträger-Akkumulierung bei der Verwendung eines bipolaren Transistors als Eingangstransistor dadurch nicht vollständig ausgeglichen werden kann, daß lediglich eine Diode eingefügt wird.

Aufgabe der Erfindung ist es, bei einem aus mehreren Transistoren zusammengesetzten Transistorelement derartige Nachteile zu vermeiden und ein zusammengesetztes Transistorelement zu liefern, das mit geringen Schaltverlusten und hoher Schaltgeschwindigkeit betrieben werden kann.

Diese Aufgabe wird gemäß dem Kennzeichen des Anspruchs 1 durch eine Kombination von Feldeffekttransistoren mit einem bipolaren Transistor gelöst.

Die Erfindung geht folglich davon aus, daß ein bipolarer Transistor in Verbindung mit einem Satz von Feldeffekt- transistoren zum Schalten des bipolaren Transistors verwendet wird. Ein FET ist dabei mit seinem Drain-Anschluß und seinem Source-Anschluß zwischen dem Kollektor und dem Basisanschluß des bipolaren Transistors angeschlossen, während Drain und Source des anderen FET an Basis und Emitter des bipolaren Transistors angeschlossen ist.

Die erfindungsgemäße Schaltung ist insbesondere als Treiberstufe oder als Transistorschalter für höhere Leistungen, z.B. bei Transistor-Umrichtern, geeignet.

Die Erfindung wird anhand von drei Ausführungsbeispielen und drei weiteren Figuren näher erläutert.

In den Figuren 2 bis 4 ist jeweils mit C, B und E Kollektor, Basis und Emitter des bipolaren Transistors 2 bezeichnet. D, S und G bezeichnen Drain, Source und Gate von Mos-Feldeffekttransistoren 4 und 5 bzw. von Junction-Transistoren 7 und 8.

In Fig. 2 ist der Transistor 4 ein n-Kanal-MOS-FET und der Transistor 5 ein p-Kanal-MOS-FET. Die Basis B des Transistors 2 ist mit dem Source-Anschluß S des FET 4 und der Kollektor C mit dem Drain-Anschluß D des FET 4 verbunden. Ferner ist die Basis D des Transistors 2 mit dem Drain-Anschluß D des FET 5 und der Emitter E des Transistors 2 mit dem Source-Anschluß S des FET 5 verbunden. Bei dieser Konfiguration der MOS-FET können die Gate-Anschlüsse G miteinander verbunden werden, so daß ein Schalter mit drei Anschlüssen gebildet wird.

Obwohl ein npn-Transistor 2 bei diesem Ausführungsbeispiel verwendet wird, kann auch ein pnp-Transistor verwendet werden. Selbstverständlich sind dabei der FET 4 und der FET 5 durch einen p-Kanal-MOS-FET bzw. einen n-Kanal-MOS-FET zu ersetzen.

0109576

Die Arbeitsweise des Ausführungsbeispiels nach Fig. 2 ist folgende:

Wenn in der Leitfähigkeitsphase z.B. eine Steuerspannung von + 10 V an das Gate G gelegt wird, so fließt durch den n-Kanal MOS-FET 4, der zwischen Basis und Kollektor des Transistors 2 geschaltet ist, ein entsprechender Basisstrom auf den Transistor 2 und schaltet diesen leitfähig. Da dann der Transistor 2 praktisch mit Basis und Kollektor kurzgeschlossen ist, sinkt die Kollektor-Emitterspannung nicht unter die Basis-Emitter-Sättigungsspannung, selbst wenn der Widerstand in der Leitfähigkeitsphase praktisch Null ist. Der Transistor 2 arbeitet im aktiven Bereich, wo eine geringere Ladungsträger-Akkumulierung in der Basiszone auftritt. Die unerwünschte Wirkung von Ladungsträger-Akkumulierung kann daher in der gleichen Weise verringert werden, wie bei der üblichen Schaltung nach Fig. 1, die den bipolaren Transistor 1 als Eingangsstufe enthält. Da ferner als Transistor 4 ein MOS-FET verwendet ist, treten nur kleinere Kapazitäten auf als bei dem bipolaren Transistor 1 in Fig. 1.

Ist im gesperrten Zustand eine Steuerspannung von 0 V oder -10 V an das Gate gelegt, so ist FET 4 gesperrt und der p-Kanal-MOS-FET 5 zwischen Basis und Emitter des Transistors 2 ist leitend. Dadurch ist ein dem Leitfähigkeitszustand des Transistors 2 entsprechender Steuerstrom unterbrochen. Vielmehr fließt ein entgegengesetzter Basisstrom durch den FET 5, entsprechend der Kontaktspannung am Basis-Emitter-Übergang des Transistors 2, und die akkumulierten Ladungsträger in der Basiszone werden abgesaugt. Da ferner der Transistor 5 ebenfalls ein MOS-FET ist, treten kleinere Kapazitäten auf als im Transistor 1 in Fig. 1.

Es ist allgemein bekannt, daß sich bei Feldeffekttransistoren praktisch keine Ladungsträger-Akkumulierungen auswir-ken und diese eine sehr hohe Schaltgeschwindigkeit haben. Daher wird bei dem zusammengesetzten Schaltelement nach der Erfindung durch die Verwendung von Feldeffekttransistoren 4 und 5, die dem bipolaren Transistor der Ausgangsstufe vor- und nachgeschaltet sind, die Ausschaltzeit verkürzt gegenüber dem üblichen Transistorelement der Fig.1, wo ein bipolarer Transistor als Eingangsstufe verwendet ist. Verwendet man ferner bei dieser Ausführung einen Ausschalt-Steuerstrom, der nur auf den erforderlichen Kurzschluß von Basis und Emitter des bipolaren Transistors 2 in der Ausgangsstufe abgestimmt ist, so erreicht man Ausschaltdauern, die für viele Anwendungszwecke hinreichend kurz sind. Da außerdem das Ansteuern sowohl zum Einschalten wie zum Ausschalten mittels Feldeffekttransistoren geschieht, kann die Ausgangsspannung praktisch allein durch Ein- und Ausschalten mittels der Steuerspannung gesteuert werden und die Leistungsverluste sind insgesamt geringer.

Fig. 3 und 4 zeigen weitere Ausführungsformen der Erfindung. Fig. 3 unterscheidet sich dabei von Fig. 2 darin, daß der FET 5 durch einen n-Kanal-FET 6 ersetzt ist und die Gate-Anschlüsse des FET 4 und FET 6 getrennt sind.

Im Gegensatz zur Fig. 2 sind die FET 4 und 5 nach Fig. 4 ersetzt durch Junction-Feldeffekttransistoren 7 und 8, deren Gates G voneinander getrennt sind. Transistor 7 ist ein n-Kanal-FET und Transistor 8 ein p-Kanal-FET. Anstelle des npn-Transistors 2 kann auch ein pnp-Transistor verwendet werden. In diesem Fall sind die Transistoren 7 und 8 durch einen p-Kanal- bzw. n-Kanal-Transistor zu ersetzen.

Wir Wirkungsweise der Schaltungen nach den Figuren 3 und 4 ist im wesentlichen die nach Fig. 2, lediglich sind die Steuersignale für die beiden Schaltzustände entsprechend den beiden Gates an getrennte Eingänge zu legen.

Da also nach der Erfindung ein bipolarer Transistor mit hoher Kapazität und Feldeffekttransistoren kleiner Kapazität miteinander kombiniert sind, um einen hohen Strom mittels einer Steuerspannung durch Ein- und Ausschalten zu regeln oder steuern und dabei die Auswirkungen von Ladungsträger-Akkumulierungen zu verringern, kann auf diese Weise ein zusammengesetzter Transistor als Treiberstufe mit niedrigem Leistungsverlust und kurzen Schaltdauern geschaffen werden. Diese kann mit drei Anschlüssen unter Verwendung von MOS-FETs ausgebildet sein und bildet einen einfachen Treiberschaltkreis mit wesentlich verringertem Leistungsverbrauch. Dadurch sind eine erheblich verringerte Baugröße und ein erhöhter Wirkungsgrad bei geringen Kosten des Elementes erreicht.

Patentansprüche

1. Zusammengesetztes Transistorelement mit einem bipolaren Transistor (2), g e k e n n z e i c h n e t d u r c h zwei Feldeffekt-Transistoren (4, 5) zum Ein- und Ausschalten des bipolaren Transistors, wobei der eine Feldeffekttransistor (4) mit Drain (D) und Source (S) zwischen Kollektor und Basis und der andere Feldeffekttransistor (5) mit Drain und Source zwischen Basis (B) und Emitter (E) des bipolaren Transistors (2) geschaltet ist.

2. Verwendung des zusammengesetzten Transistorelements nach Anspruch 1 als Schaltelement für Geräte der Leistungselektronik.

FIG 1

FIG 2

FIG 3

FIG 4